Europäisches Patentamt

European Patent Office

Office européen des brevets

(19)

(11) Publication number: **0 531 101 A2**

# EUROPEAN PATENT APPLICATION

(12)

(21) Application number: **92307945.3**

(22) Date of filing: **02.09.92**

(51) Int. Cl.5: **G05F 1/46**

(30) Priority: **05.09.91 US 755002**

(43) Date of publication of application:
**10.03.93 Bulletin 93/10**

(84) Designated Contracting States:
**DE FR GB NL**

(71) Applicant: **TriOuint Semiconductor, Inc.**
**3601 S.W. Murray, Group 700 P.O. Box 4935**
**Beaverton Oregon 97076(US)**

(72) Inventor: **Weiss, Frederick**
**17810 N.E. Courtney Road**
**Newberg, Oregon 97132(US)**

(74) Representative: **Burke, Steven David et al**
**R.G.C. Jenkins & Co. 26 Caxton Street**
**London SW1H 0RJ (GB)**

(54) **Low-noise bias circuit for multiple current sources.**

(57) A bias circuit includes a plurality of current generating stages for generating a plurality of reference currents, a plurality of cascode stages, a bias voltage generator, and a low impedance driver circuit for supplying a low impedance bias voltage to the cascode stages. The low impedance of the driver circuit reduces the generated noise voltage and the interaction between the current sources, minimizing noise amplification. The driver circuit includes a number of high input impedance, low output impedance buffer amplifiers. The input of each buffer amplifier receives the generated bias voltage, and the low impedance output of each buffer amplifier is coupled to the bias voltage input of one or more cascode stages. For maximum noise reduction, the bias circuit further includes a filter stage coupled between one of the buffer amplifier outputs and the bias voltage input of each of the cascode stages. If multiple cascode stages are used in the current sources, a second embodiment of the driver circuit generates multiple low impedance bias voltage outputs for driving the bias voltage input of each cascode stage. The driver circuit includes rows of buffer amplifiers. A first row of buffer amplifiers has multiple outputs for driving a first bias voltage input of one or more of the cascode stages. Additional rows are used as needed to drive additional levels of bias inputs. The second embodiment of the driver circuit can be used in conjunction with filter stages for improved performance.

Fig. 5

## BACKGROUND OF THE INVENTION

This invention relates generally to bias circuits and more particularly to bias circuits including multiple current sources typically used in precision digital-to-analog converter circuits ("DAC") and other precision integrated circuits.

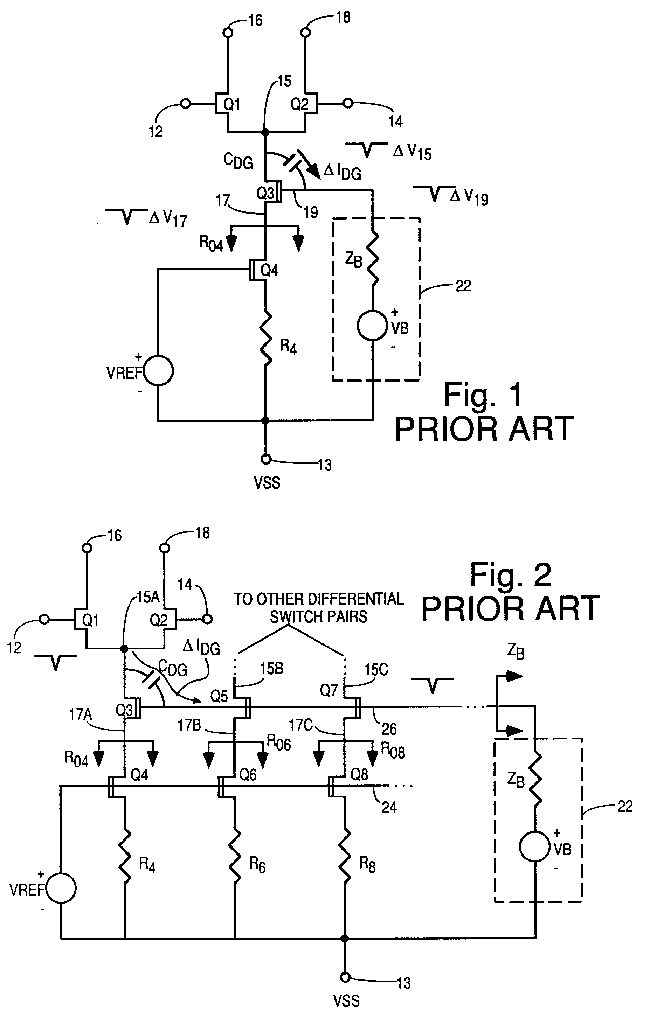

Referring to FIG. 1, a DAC has a number of differential pairs of transistors typified by transistors Q1 and Q2 biased with binarily weighted current sources that transform a digital input into an analog current output. The current source is typically a cascode type current source including a current generator (VREF, Q4, and R4) and a cascode stage (Q3). The cascode stage is used to desirably increase the output impedance $R_{o4}$ of the current generating transistor Q4 as is known in the art. Transistors Q1 and Q2 receive a differential voltage input at nodes 12 and 14 to direct output current through either output node 16 or 18. When the differential pair of transistors is switched, the common source node 15 bounces by several hundred millivolts, driving a displacement current ($\Delta I_{DG}$)into the cascode transistor Q3 via the parasitic drain-to-gate capacitance ($C_{DG}$).This displacement current develops a voltage transient at the gate of transistor Q3 due to the non-zero impedance of the bias generator 22 ($Z_B$). The transient voltage developed at the gate node 19 of transistor Q3 also modulates the voltage at the source node 17, which causes the current flowing in the current generator Q4-R4 to change. The change in the drain current of transistor Q4, $\Delta I_{D4}$, is given by the following equation:

$$\Delta I_{D4} = \Delta V_{17}/R_{o4},$$

where $R_{o4}$ is the output impedance of the current generator Q4-R4. The current flowing into node 15, which is the total effective current generator output, current changes according to the following equation:

$$\Delta I_{15} = \Delta I_{DG} + \Delta I_{D4}.$$

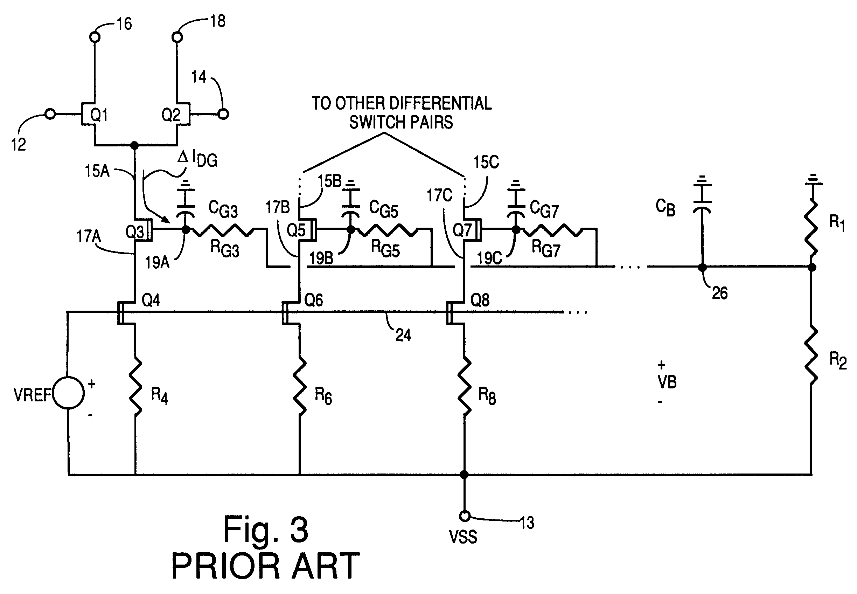

Referring now to FIG. 2, multiple current sources are shown as is typically found in a DAC (only three are shown in FIG. 2.) Transistors Q5-Q6 and resistor R6 generate a bias current that flows through conductor 15B, and transistors Q7-Q8 and resistor R8 generate a bias current that flows through conductor 15C. The current provided by each current source is typically directed to an associated differential pair of transistors (additional pairs not shown in FIG. 2). In turn, the current outputs of all of the differential pairs are summed to provide the total analog output current at output nodes 16 and 18. Cascode transistors Q3, Q5, and Q7 respectively increase the output impedances $R_{o4}$, $R_{o6}$, and $R_{o8}$, and are biased from a common cascode bias line 26. Bias generator 22 is represented by a voltage generator $V_B$ in series with an associated impedance $Z_B$. Each of the current sources is also voltage biased through a common bias line 24 coupled to the VREF voltage source, which, along with the respective source resistors, sets the values of the bias currents. Multiple additional current sources can coupled to the bias line 24 and the cascode bias line 26. The displacement current $\Delta I_{DG}$ flowing through the parasitic drain-to-gate capacitance $C_{DG}$ of transistor Q3, due to the switching of transistors Q1 and Q2, causes all of the other current sources to be modulated through their respective cascode stages coupled to the common cascode-bias line 26. This results in an undesirable net amplification of the switching noise at node 15A, since all of the modulated currents are ultimately summed at the outputs 16, 18. In addition, settling time is degraded. As is known in the art, the voltage bias generator 22 can take many forms such as a simple resistor divider, a current source and diode, and operational amplifier-based circuits. All of these circuits, however, have a non-zero impedance that develops noise voltage and noise amplification in response to the switching displacement current. In addition, the noise is still further amplified when multiple differential pairs of transistors are switched at the same time.

The circuit of FIG. 3 shows one circuit configuration that minimizes voltage noise and current source interaction. The gates of each of the cascode transistors Q3, Q5, and Q7 are biased from the common voltage bias generator (R1 and R2 resistor divider) through simple passive resistor-capacitor filter stages $R_{G3}$-$C_{G3}$, $R_{G5}$-$C_{G5}$, and $R_{G7}$-$C_{G7}$. The input of each of the filter networks is coupled to the bias line 26, and the output is coupled to the gate of the respective cascode transistor at nodes 19A, 19B, and 19C. The filter networks isolate each gate from the bias line 26 with a low-pass filter such that any high frequency noise on bias line 26 is significantly attenuated at the respective gate nodes 19A-19C, thus reducing the modulation of the respective current sources. Additionally, the filter capacitors $C_{G3}$, $C_{G5}$, and $C_{G7}$ bypass each $\Delta I_{DG}$ displacement current to ground, reducing the noise at each gate node. Further filtering is provided by the low-pass filtering of resistors $R_{G3}$, $R_{G5}$, and $R_{G7}$ in conjunction with capacitor $C_B$, which minimizes noise injected from nodes 19A-19C onto bias line 26.

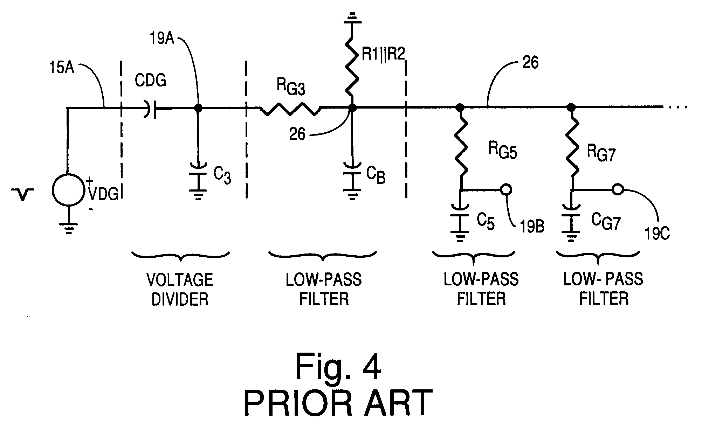

An AC equivalent circuit for the circuit of FIG. 3 is shown in FIG. 4. The noise voltage on node 15A is represented by an AC voltage generator $V_{DG}$. Capacitors $C_{DG}$ and $C_{G3}$ form a voltage divider that reduces the noise voltage according to the ratio of the capacitors. Resistors R1, R2, and $R_{G3}$, in conjunction with capacitor $C_B$ form a first low-pass filter that filters the high frequency components of the gate noise voltage onto bias line 26. A second low-pass filter is formed at the gate of each of the remaining current sources. Thus gate node 19B is further filtered by low-pass filter $R_{G5}$-$C_{G5}$, and gate node 19C is further filtered by low-pass filter $R_{G7}$-$C_{G7}$.

One problem with the improved performance of the circuit of FIG. 3 is that, at very high DAC resolutions at and above 10-bit resolution, the amount of noise amplification and the length of the settling time are still unacceptable. For example, a noise voltage at the bias line 26 of 10 mV may result in an acceptable error of about two least significant bits (2 LSBs) for an 8-bit DAC. For a 14-bit DAC, the same 10 mV of noise voltage can result in an unacceptably high error of one hundred sixty least significant bits (160 LSBs).

Accordingly, a need remains for a method of further reducing the generation and amplification of noise in a multiple current source bias circuit.

## SUMMARY OF THE INVENTION

It is, therefore, an object of the invention to increase the resolution and improve the settling time of a DAC.

Another object of the invention is to provide a low noise multiple current source bias circuit.

It is a feature of the invention that the low noise bias current generator can be fabricated on an integrated circuit.

According to the present invention, a bias circuit includes a plurality of current generating stages for generating a plurality of reference currents, a plurality of cascode stages, a reference voltage source, a cascode bias generator, and a low impedance driver circuit for supplying a low impedance bias voltage to the cascode stages. The low impedance of the driver circuit reduces the generated noise voltage and the interaction between the current sources, minimizing noise amplification. The driver circuit includes a number of high input impedance, low output impedance buffer amplifiers. The input of each buffer amplifier receives the generated cascode bias voltage, and the low impedance output of each buffer amplifier is coupled to the bias voltage input of one or more cascode stages. For maximum noise reduction, the bias circuit further includes a filter stage coupled between one of the buffer amplifier outputs and the bias voltage input of each of the cascode stages. If multiple cascode stages are used in the current sources, a second embodiment of the driver circuit generates multiple low impedance bias voltage outputs for driving the bias voltage input of each cascode stage. The driver circuit includes rows of buffer amplifiers. A first row of buffer amplifiers accepts a common first cascode bias voltage, and has multiple outputs for driving a first bias voltage input of one or more of the first cascode stages. Additional rows are used as needed to drive additional levels of cascode bias inputs, wherein each row in turn accepts a different cascode bias input. The second embodiment of the driver circuit can be used in conjunction with filter stages for improved performance.

The foregoing and other objects, features and advantages of the invention will become more readily apparent from the following detailed description of a preferred embodiment of the invention which proceeds with reference to the accompanying drawings.

## BRIEF DESCRIPTION OF THE DRAWINGS

FIG. 1 is a schematic diagram of a portion of a DAC.

FIG. 2 is a schematic diagram of a larger portion of a DAC including multiple current sources.

FIG. 3 is a schematic diagram of a prior art low noise bias circuit.

FIG. 4 is an AC equivalent circuit of the circuit shown in FIG. 3

FIG. 5 is a schematic diagram of a first embodiment of the invention.

FIGs. 6A-6C are schematic diagrams of buffer amplifiers suitable for use in the present invention.

FIGs. 7-8 are alternative embodiments of the present invention.

## DETAILED DESCRIPTION

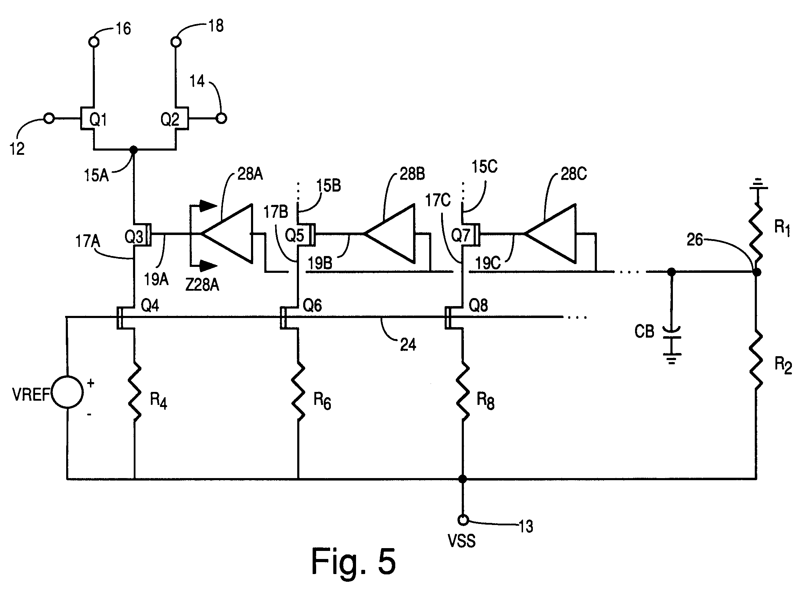

Referring now to FIG. 5, a first embodiment of the bias circuit includes a plurality of current generating stages Q4-R4, Q6-R6, and Q8-R8 for generating a number of reference currents. Only three current generating stages are shown, but additional stages can be added and biased from the same bias line 24. Bias line 24 appropriately supplies a voltage bias generated by a voltage source designated VREF. An equal number of cascode stages Q3, Q5, and Q7 increases the output impedance of each of the current generating stages. The input (FET source node) of each cascode stage has an input for receiving the respective reference current through conductors 17A, 17B, and 17C. The output of each of the cascode stages provides a high impedance reference current to the source node of a pair of transistors through conductors 15A, 15B, and 15C. It is appreciated by those skilled in the art that the reference currents may be delivered to other circuit blocks besides switched differential pairs of transistors. Each cascode stage Q3, Q5, and Q7 has a bias voltage input (FET gate terminal) for receiving a biasing voltage. The voltage for biasing the cascode stages is generated by voltage divider circuit R1, R2, and capacitor $C_B$. The generated bias voltage appears on bias line 26. Capacitor $C_B$ provides noise filtering as discussed above. In the preferred embodiment, transistors Q1 and Q2, and other differential pairs of transistors not shown, are enhancement FETs. Transistors Q3-Q8 are depletion FETs, which are normally on when the gate-to-source voltage ("$V_{GS}$") is zero. Depletion FETs may be desirable since less voltage and less physical die area are necessary to generate the bias currents.

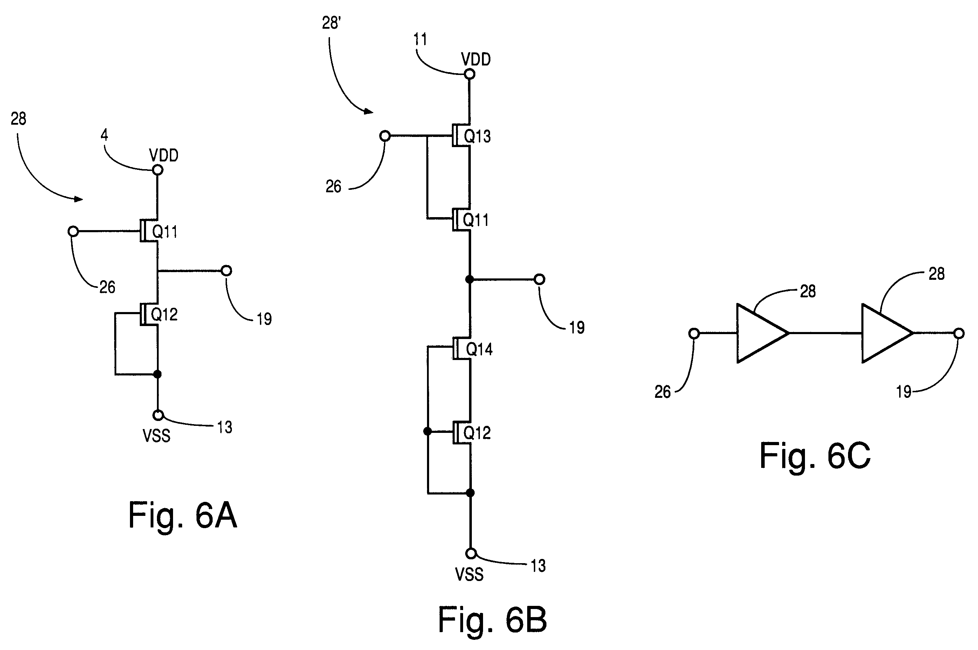

In the circuit of FIG. 5, the bias line 26 is not used to directly bias the voltage reference inputs of the cascode stages. An intermediate driver circuit including buffer amplifiers 28A, 28B, and 28C drives the cascode bias voltage inputs with an impedance that is less than that of the bias voltage generator. Each cascode stage, therefore, is buffered from the bias voltage generator with a buffer amplifier having unity voltage gain, good reverse isolation, and low output impedance. The low output impedance minimizes the voltage noise spike $\Delta V_{DG}$ appearing at nodes 19A-19C due to the displacement current $\Delta I_{DG}$ referred to in conjunction with FIGS. 1-2. The reverse isolation minimizes noise transfer from one cascode stage to all other cascode stages through bias line 26. Three embodiments of suitable buffer amplifiers are shown in FIGS. 6A-6C. Other embodiments, however, can be used. Buffer amplifier 28 shown in FIG. 6A includes transistors Q11 and Q12. The gate of transistor Q11 forms the input and the source of transistor Q11 forms the output of buffer amplifier 28. Transistor Q12 is a current source for biasing transistor Q11. In the buffer amplifier 28' of FIG. 6B, input transistor Q11 further includes a cascode stage transistor Q13. In addition, the current source transistor Q12 also includes a cascode stage transistor Q14. The cascode stages improve the output impedance, gain, and power supply rejection of the amplifier. FIG. 6C shows a buffer amplifier that includes two series-connected buffer amplifier stages 28 for improving reverse isolation.

One problem with the circuit configuration shown in FIG. 5 is that one buffer amplifier 28 must be included to drive the voltage reference input 19 of each cascode stage. While this approach improves noise performance, it may be undesirable for purposes of fabrication on an integrated circuit. Specifically, for circuits requiring numerous reference currents, an undesirably large area of the integrated circuit must be added solely for the buffer amplifiers 28. In addition, the power requirements of the buffer amplifiers 28 can undesirably increase the overall power requirement of the integrated circuit.

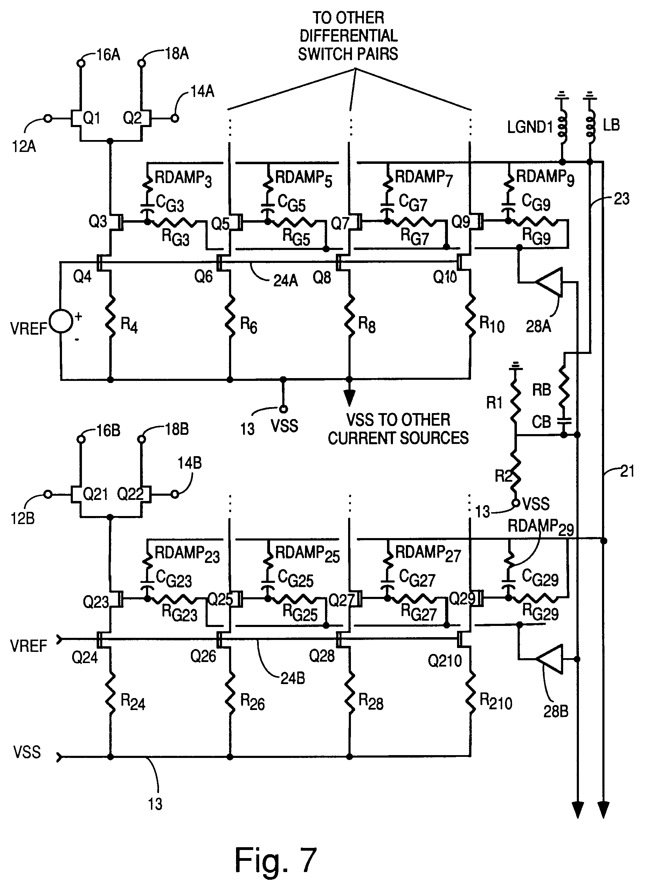

One approach for maintaining the increased noise performance while reducing the number of buffer amplifiers 28 used is shown in the bias circuit of FIG. 7. In FIG. 7, the output of two buffer amplifiers 28A and 28B are respectively coupled to the bias voltage input of a predetermined number of cascode stages. In the circuit of FIG. 7, buffer amplifier 28A drives the bias voltage input of cascode stages Q3, Q5, Q7, and Q9, while buffer amplifier 28B drives the bias voltage input of cascode stages Q23, Q25, Q27, and Q29. Thus, the effective source impedance of the bias voltage generator to the bias input of the cascode stages is still reduced, but six out of eight buffer amplifiers 28 are eliminated.

In FIG. 7 it is important to note that, although two buffer amplifiers are shown driving a total of eight current sources, the exact number of buffer amplifiers and current sources can be changed, and need not be changed by a constant ratio. For example, one buffer amplifier can drive three current sources, while a second buffer amplifier drives five current sources, while a third buffer amplifier drives seven current sources. If high noise immunity is desired in any one current source, a single buffer amplifier can be used to drive that particular current source.

The noise performance, however, is slightly degraded by the circuit of FIG. 7 due to the effective increase in driving impedance caused by the reduction in the number of buffer amplifiers. Noise reduction can be restored to the level of the circuit shown in FIG. 5 by adding passive filter stages. Thus, in the first group of current sources, filter stages $R_{G3}$-$C_{G3}$, $R_{G5}$-$C_{G5}$, $R_{G7}$-$C_{G7}$, and $R_{G9}$-$C_{G9}$ each have an input coupled to the output of buffer amplifier 28A and an output coupled to the bias voltage input of the respective cascode stages Q3, Q5, Q7, and Q9. Similarly, in the second group of current sources, filter stages $R_{G23}$-$C_{G23}$, $R_{G25}$-$C_{G25}$, $R_{G27}$-$C_{G27}$, and $R_{G29}$-$C_{G29}$ each have an input coupled to the output of buffer amplifier 28B and an output coupled to the bias voltage input of the respective cascode stages Q23, Q25, Q27, and Q29.

As in all integrated circuits, a finite inductance exists between metal runs such as the ground bus 21 and earth ground due to bond wires, circuit packaging, and the circuit board upon which the integrated circuit is mounted. Therefore, a damping resistor is coupled between each filter capacitor and ground bus 21. In the first group of current sources, damping resistors $R_{DAMP3}$, $R_{DAMP5}$, $R_{DAMP7}$, and $R_{DAMP9}$ prevent an undesirable oscillation at a frequency determined by the respective filter capacitors and parasitic inductance $L_{GND1}$. Similarly, in the second group of current sources, damping resistors $R_{DAMP23}$, $R_{DAMP25}$, $R_{DAMP27}$, and $R_{DAMP29}$ also prevent an undesirable oscillation. The bias voltage provided by bias voltage generator R1, R2, and $C_B$ is also damped by $R_B$ to prevent an oscillation at a frequency determined by capacitor $C_B$ and parasitic inductance $L_B$ associated with conductor 23.

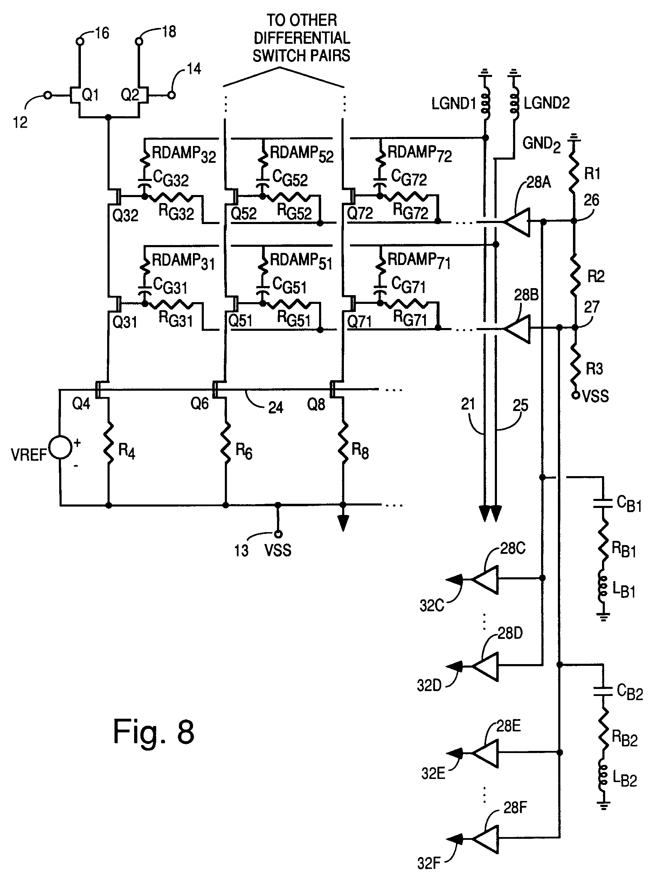

The buffered and filtered circuit topology of FIG. 7 can be extended to multi-level cascode stage bias circuits as shown in FIG. 8. Multi-level cascode stages are used to further increase output impedance. The output impedance of short channel FETs as are used in GaAs circuits, for example, can be quite low and thus benefits from multiple levels of cascode stages. The bias circuit of FIG. 8 includes a plurality of current generating stages in multiple rows. A first row includes current generating transistors Q4, Q6, Q8, while the corresponding current generating transistors of other rows are not shown. The number of rows and number of current sources within each row can be varied depending upon the application. A plurality of cascode stages Q31-Q32, Q51-Q52, and Q71-Q72 each has an input (source of the lower transistor in the stage) for receiving the respective reference current, and an output at the drain of the upper transistor in the pair. In the circuit of FIG. 8, however, each cascode stage includes two bias voltage inputs for voltage biasing the gate of each transistor in the stage. Likewise, the cascode bias voltage generator includes resistors R1, R2, and R3 for generating two cascode bias voltages. The generated bias voltages at nodes 26 and 27 each have an associated impedance that is too high for driving the cascode stages directly. Therefore a driver circuit including buffer amplifiers 28A and 28B is included for driving the bias voltage inputs of each of the cascode stages with an impedance less than the impedance associated with nodes 26 and 27.

The driver circuit includes a number of buffer amplifiers. Buffer amplifiers 28A-28B drive a first group of current sources via output driver busses 30 and 31, buffer amplifiers 28C-28D drive a second group of current sources via output driver busses 32C and 32D, and buffer amplifiers 28E-28F drive a third group of current sources via output driver busses 32E and 32F. Only the first group of current sources is shown in FIG. 8. Additional groups of current sources can be added, and the number of current sources within each group varied. Buffer amplifier 28A has a common input for receiving a first generated bias voltage at node 26 and an output for driving a first bias voltage input (gate of transistors Q32, Q52, and Q72) of each cascode stage. A second buffer amplifier 28B also has a common input for receiving a second generated bias voltage at node 27. The output of buffer amplifier 28B drives a second bias voltage input (gate of transistors Q31, Q51, and Q71) of each cascode stage. The cascode stages are shown to have two bias voltage inputs in FIG. 8, but three or more may be used depending upon the level of performance required.

As in the circuit of FIG. 7, damping is required to prevent oscillation at a frequency determined by the various filter capacitances and the parasitic inductances. In the circuit of FIG. 8, resistors $R_{DAMP32}$, $R_{DAMP52}$, and $R_{DAMP72}$ damp the oscillation due to capacitors $C_{G32}$, $C_{G52}$, and $C_{G72}$ and the parasitic inductance $L_{GND1}$ associated with ground conductor 21. Similarly, resistors $R_{DAMP31}$, $R_{DAMP51}$, and $R_{DAMP71}$ damp the oscillation due to capacitors $C_{G31}$, $C_{G51}$, and $C_{G71}$ and the parasitic inductance $L_{GND2}$ associated with ground conductor 25. Each of the generated bias voltages at nodes 26 and 27 are filtered and damped with separate series-connected passive circuits. Node 26 is filtered and damped with the series combination of $C_{B1}$-$R_{B1}$, and node 27 is filtered and damped with the series combination of $C_{B2}$-$R_{B2}$.

In the circuits shown in FIGS. 5-8, the component values and current sources groupings are dependent upon the level of noise reduction desired. In some applications, many current sources can be driven by one buffer amplifier, and filtering may or may not be required. In other applications, each current source may require a separate buffer amplifier in conjunction with filtering as shown in FIGS. 7-8. Exact component values cannot be provided without knowledge of the exact application specifications. Thus, it is desirable in each application to perform a simulation using trial values, and to optimize the performance using successive simulations and/or fabrications of test integrated circuits. As a general rule-where multiple levels of cascode stages are used, it may be desirable to use a greater number of buffer amplifiers in the uppermost cascode stages since these stages will generate the most noise. While the description of the invention refers to and the schematic drawing figures show GaAs FETs, it is apparent to those skilled in the art that other types of active devices such as bipolar junction transistors, NMOS/CMOS FETs, or combinations thereof can be easily substituted.

Having described and illustrated the principles of the invention in a preferred embodiment thereof, it should be apparent that the invention can be modified in arrangement and detail without departing from such principles. I claim all modifications and variation coming within the spirit and scope of the following claims.

**Claims**

1. A bias circuit comprising:

    a plurality of current generating stages for generating a plurality of reference currents;

    a plurality of cascode stages each having an input for receiving the respective reference current, an output, and a bias voltage input;

    means for generating a bias voltage having an associated first impedance; and

    means for driving the bias voltage at the bias voltage input of each of the cascode stages with a second impedance less than the first impedance.

2. The bias circuit of claim 1 in which the driving means comprises a plurality of high input impedance, low output impedance buffer amplifiers, each buffer amplifier having an input for receiving the generated bias voltage, and an output coupled to the bias voltage input of the respective cascode stage.

3. The bias circuit of claim 1 in which the driver means comprises a plurality of high input impedance, low output impedance buffer amplifiers, each buffer amplifier having an input for receiving the generated bias voltage, and an output coupled to the bias voltage input of a predetermined number of cascode stages.

4. The bias circuit of claim 3 in which at least one of the buffer amplifiers comprises an FET having a gate forming the input and a source coupled to a current source forming the output.

5. The bias circuit of claim 4 in which the FET further comprises a cascode stage.

6. The bias circuit of claim 4 in which the current source further comprises a cascode stage.

7. The bias circuit of claim 3 in which at least one of the buffer amplifiers comprises two series-connected buffer amplifier stages.

8. The bias circuit of claim 3 further comprising a plurality of filter stages, each filter stage having an input coupled to one of the buffer amplifier outputs and an output coupled to the bias voltage input of the respective cascode stage.

9. The bias circuit of claim 8 in which the filter stage comprises a resistor-capacitor low-pass network.

10. The bias circuit of claim 8 in which the filter stage comprises a resistor coupled between the filter input and filter output, and a series-connected capacitor and damping resistor coupled between the filter output and ground.

11. The bias circuit of claim 1 further comprising means for filtering the voltage at the bias voltage input of each of the cascode stages.

12. The bias circuit of claim 1 in which the means for generating a bias voltage further comprises means for filtering the generated bias voltage.

13. A bias circuit comprising:

    a plurality of current generating stages for generating a plurality of reference currents;

    a plurality of cascode stages each having an input for receiving the respective reference current, an output, and a plurality of bias voltage inputs;

    means for generating a plurality of bias voltages each having an associated impedance; and

    means for driving the bias voltage inputs of each of the cascode stages with an impedance less than the impedance associated with the respective generated bias voltage.

14. The bias circuit of claim 13 in which the driver means comprises a plurality of high input impedance, low output impedance buffer amplifiers, a first buffer amplifier having an input for receiving a first generated bias voltage and an output for driving a first bias voltage input of one or more cascode stages up to and including an Nth buffer amplifier having an input for receiving an Nth generated bias voltage and an output for driving an Nth bias voltage input of one or more cascode stages, wherein N is an integer greater than one.

15. The bias circuit of claim 13 further comprising a plurality of filter stages, each filter stage having an input coupled to one of the buffer amplifier outputs and an output coupled to the bias voltage input of the respective cascode stage.

16. The bias circuit of claim 15 in which the filter stage comprises a resistor coupled between the filter input and filter output, and a series-connected capacitor and damping resistor coupled between the filter output and ground.

17. The bias circuit of claim 13 further comprising means for filtering the voltage at the bias voltage input of each of the cascode stages.

18. The bias circuit of claim 13 in which the means for generating a bias voltage further comprises a plurality of networks including a series-connected capacitor and a damping resistor for filtering each of the generated bias voltages.

19. A method of reducing noise in a multiple current bias circuit, the method comprising the steps of:

generating a plurality of reference currents;

providing a plurality of cascode stages each having an input for receiving the respective reference current, an output, and a bias voltage input;

generating a bias voltage having an associated first impedance; and

driving the bias voltage at the bias voltage input of each of the cascode stages with a second impedance less than the first impedance.

20. The method of claim 19 in which the step of driving the reference voltage inputs comprises:

providing a plurality of high input impedance, low output impedance buffer amplifiers;

impressing the generated bias voltage on the input of each buffer amplifier; and

coupling the output of each buffer amplifier to the bias voltage input of the respective cascode stage.

21. The method of claim 19 in which the step of driving the reference voltage inputs comprises:

providing a plurality of high input impedance, low output impedance buffer amplifiers;

impressing the generated bias voltage on the input of each buffer amplifier; and

coupling the output of each buffer amplifier to the bias voltage input of a predetermined number of cascode stages.

22. The bias circuit of claim 19 further comprising the step of filtering the voltage at the bias voltage input of each of the cascode stages.

23. The bias circuit of claim 19 further comprising the step of filtering the generated bias voltage.

24. A method of reducing noise in a multiple current bias circuit, the method comprising the steps of:

generating a plurality of reference currents;

providing a plurality of cascode stages each having an input for receiving the respective reference current, an output, and a bias voltage input;

generating a plurality of bias voltages each having an associated impedance; and

driving the bias voltage at the bias voltage inputs of each of the cascode stages with an impedance less than the impedance associated with the respective generated bias voltage.

25. The method of claim 24 in which the step of driving the reference voltage inputs comprises:

providing a plurality of high input impedance, low output impedance buffer amplifiers;

impressing a first generated bias voltage on the input of a first buffer amplifier;

coupling the output of the first buffer amplifier to a first bias voltage input of one or more of the cascode stages; and

repeating the impressing and coupling steps for each level of bias voltage inputs.

26. The bias circuit of claim 24 further comprising the step of filtering the voltage at the bias voltage input of each of the cascode stages.

27. The bias circuit of claim 24 further comprising the step of filtering each of the generated bias voltages.

Fig. 1
PRIOR ART

Fig. 2
PRIOR ART

EP 0 531 101 A2

16 18 14

Q1 Q2

12

TO OTHER DIFFERENTIAL
SWITCH PAIRS

15A

$\Delta I_{DG}$

15B 15C

17B 17C

$C_{G3}$ $C_{G5}$ $C_{G7}$ $C_B$

$R_1$

17A Q3 Q5 Q7

$R_{G3}$ $R_{G5}$ $R_{G7}$

19A 19B 19C 26

Q4 Q6 Q8

24

$R_2$

VREF + $R_4$ $R_6$ $R_8$ + VB −

−

VSS 13

Fig. 3
PRIOR ART

EP 0 531 101 A2

15A

19A

CDG

R1∥R2

RG3

26

+
VDG
−

C3

26

CB

RG5

RG7

C5

19B

CG7

19C

VOLTAGE
DIVIDER

LOW-PASS
FILTER

LOW-PASS
FILTER

LOW- PASS
FILTER

Fig. 4
PRIOR ART

Fig. 5

Fig. 6A

Fig. 6B

Fig. 6C

EP 0 531 101 A2

Fig. 7

Fig. 8